# EUROPEAN PATENT APPLICATION

(11) **EP 4 286 492 A1**
(43) Date of publication of application: **06.12.2023**
(21) Application number: 21923272.5
(22) Date of filing: 24.12.2021
(51) Int. Cl.: C09K 11/08, C09K 11/66, H01L 33/50, H01S 5/022, G02B 5/20

(54) **FLUORESCENT MATERIAL, LIGHT-EMITTING DEVICE, SENSING SYSTEM LIGHT SOURCE, AND SENSING SYSTEM ILLUMINATION SYSTEM**

(30) Priority: 29.01.2021 JP 2021012659
(71) Applicant: Panasonic Intellectual Property Management Co., Ltd., Osaka-shi, Osaka 540-6207 (JP)
(72) Inventor: NITTA Mitsuru, Kadoma-shi, Osaka 571-0057 (JP); SHIGITANI Ryosuke, Kadoma-shi, Osaka 571-0057 (JP); OSHIO Shozo, Kadoma-shi, Osaka 571-0057 (JP)
(74) Representative: Müller-Boré & Partner Patentanwälte PartG mbB
(86) International application number: PCT/JP2021/048295
(87) International publication number: WO 2022/163269

(57) **Abstract**

Provided is a phosphor that contains Cr³⁺ and emits near-infrared light, wherein a host crystal of the phosphor has a crystal structure same as that of a compound Mg₃Ga₂GeO₈, a fluorescence spectrum F_{F1} has a fluorescence peak FP_{F1} within a range of wavelengths of 700 or more and less than 900 nm, and a fluorescence spectrum data group FD that is an aggregate of spectral intensities of the fluorescence spectrum F_{F1} at every 10 nm exhibits a unimodal shape within the range of wavelengths of 700 or more and less than 900 nm.

## Description

### TECHNICAL FIELD

The present invention relates to a phosphor, a light emitting device, a sensing system light source, and a sensing system illumination system.

### BACKGROUND ART

In recent years, the demand for noncontact vital sensing is increasing. Noncontact vital sensing is a system that uses a light emitting device to irradiate a subject with visible radiation, near-infrared radiation, or the like, photographs a photographing area of the subject using a camera to obtain image data, and processes this image data using a computer to obtain vital information, for example. Vital information includes information on blood pressure, pulse waves, and blood vessels deep in a living body, for example.

The above system including a light emitting device, camera, and computer is generally also referred to as a sensing system. As a conventional light emitting device, a device outputting visible radiation, a device outputting visible radiation and near-infrared radiation, and the like are known. Also, as a camera, an RGB camera, a near-infrared camera, or the like is used.

Vital information obtained using noncontact vital sensing differs depending on the emission spectrum of the output light of the light emitting device. For example, in order to obtain blood pressure information, output light having a high intensity of optical components of a wavelength of 850 nm is preferable. In order to obtain pulse wave information, output light having a high intensity of optical components of a wavelength of 940 nm is preferable. Thus, in noncontact vital sensing, it is preferable to obtain output light having a high intensity of optical components in the near-infrared range.

Also, the accuracy of vital information obtained using noncontact vital sensing differs depending on the combination of the light emitting device and the camera. Specifically, the accuracy of vital information differs depending on characteristics of the emission spectrum of the output light of the light emitting device and characteristics of the light-receiving sensitivity of the camera.

For example, the combination of a light emitting device that outputs only visible radiation and an RGB camera may not obtain vital information in a dark place, such as at night, and may be susceptible to external disturbances such as body movement and illumination changes.

In addition, a sensing system that combines a light emitting device outputting visible radiation and near-infrared radiation with an RGB camera and a near-infrared camera is known. When a near-infrared camera is used, the receiving wavelength range is wider than that of an RGB camera alone, and it is possible to receive light of wavelengths from the visible range to the near-infrared range.

Note that the reason for combining an RGB camera and a near-infrared camera is that a CMOS image sensor used in an inexpensive RGB camera generally has a low light receiving sensitivity for near-infrared radiation.

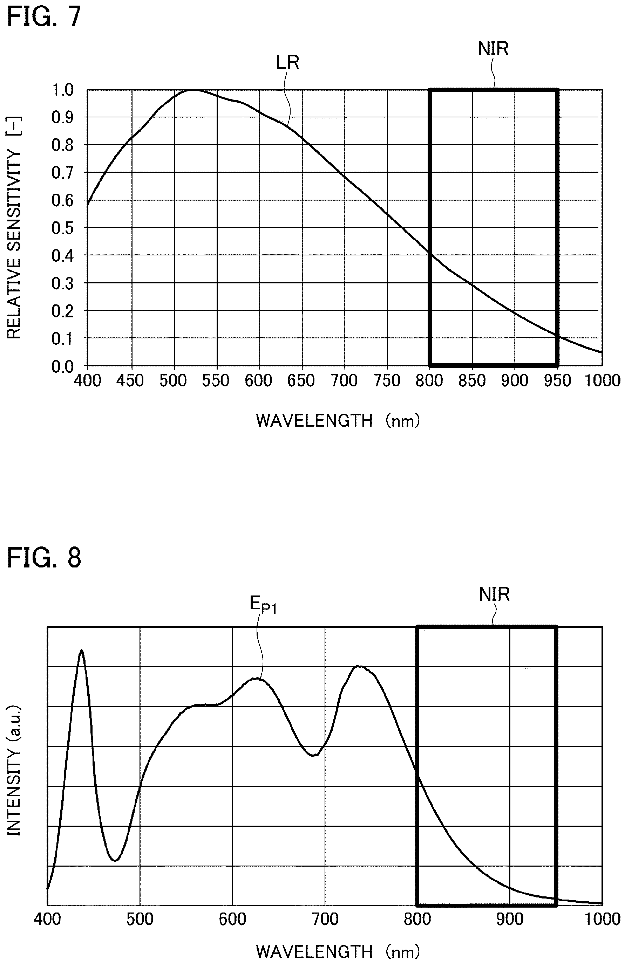

Fig. 7 is a graph illustrating an example of an LR light receiving sensitivity curve of a CMOS image sensor included in a general RGB camera. As illustrated in Fig. 7, a general CMOS image sensor has a low light receiving sensitivity in a near-infrared range NIR of wavelengths from 800 to 950 nm.

With the sensing system using an RGB camera and a near-infrared camera, it becomes possible in a dark place to estimate a heart rate and to obtain vital information such as information on blood vessels deep in a living body. However, since this sensing system uses two types of cameras having different configurations, the accuracy of the obtained vital information may easily degrade due to changes in the lighting environment. Specifically, the accuracy of the obtained vital information easily degrades due to a gap in synchronization between the near-infrared radiation output from the near-infrared LED in the light emitting device and the two types of cameras.

Thus, a sensing system combining a light emitting device and one type of CMOS image sensor is demanded. In addition, when an image including more wavelengths than RGB is acquired, it is easy to obtain a different amount of information for each wavelength, and the accuracy of the obtained vital information is expected to improve. In addition, the sensing system is preferably low-cost. Therefore, the use of a multispectral camera, a hyperspectral camera, and the like that include a general and inexpensive CMOS image sensor and acquire an image including more wavelengths than RGB is being considered.

In this sensing system, it is desired to use a light emitting device having a high emission intensity in the near-infrared range NIR (wavelength 800 to 950 nm) to cover the characteristic of a general CMOS image sensor of the light receiving sensitivity being low in the near-infrared range NIR.

As a sensing system light emitting device using a general CMOS image sensor, a light emitting device having the characteristic of an emission spectrum E_{P1} illustrated in Fig. 8 is known. However, with the emission spectrum E_{P1} of this light emitting device, the intensity in the near-infrared range NIR at wavelengths from 800 to 950 nm is low and decreases at the longer wavelength side, and thus the characteristic of the general CMOS image sensor of the light receiving sensitivity being low in the near-infrared range NIR as illustrated in Fig. 7 cannot be covered.

Also, as a phosphor considered for use in a light emitting device, an Mg₃Ga₂GeO₈ phosphor is disclosed in Non-Patent Literature 1.

### CITATION LIST

### NON-PATENT LITERATURE

Non-Patent Literature 1: Wang, et al. "Ultra-broadband near-infrared Cr3+ -activated Ga-Ge-based Mg3Ga2GeO8 phosphor as light source for food analysis" ACS Applied Electronic Materials, American Chemical Society, United States, January 2019, p. 1046-1053

### SUMMARY OF THE INVENTION

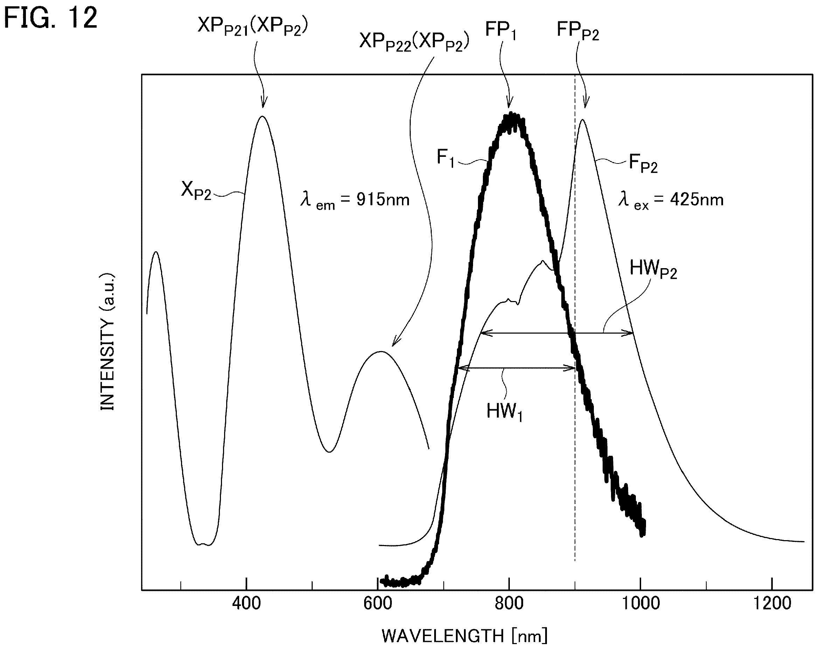

However, the Mg₃Ga₂GeO₈ phosphor disclosed in Non-Patent Literature 1 has the characteristic of a fluorescence spectrum F_{P2} (excitation wavelength λₑₓ = 425 nm) illustrated in Fig. 12 and thus is not suitable for a sensing systems using a general CMOS image sensor. Specifically, the Mg₃Ga₂GeO₈ phosphor disclosed in Non-Patent Literature 1 has a fluorescence peak FP_{P2} of the fluorescence spectrum F_{P2} exceeding 900 nm and a low intensity in the wavelength range for obtaining blood pressure information (wavelength 850 nm).

The present invention has been made in consideration of the above-described issue, which is inherent in the related art. An object of the present invention is to provide a phosphor, a light emitting device, a sensing system light source, and a sensing system illumination system that have a high fluorescence intensity in the near-infrared range (wavelength 800 to 950 nm).

In response to the above issue, a phosphor according to one aspect of the present invention contains Cr³⁺ and emits near-infrared light, wherein a host crystal of the phosphor has a crystal structure same as that of a compound Mg₃Ga₂GeO₈, a fluorescence spectrum F_{F1} has a fluorescence peak FP_{F1} within a range of wavelengths of 700 or more and less than 900 nm, and a fluorescence spectrum data group FD that is an aggregate of spectral intensities of the fluorescence spectrum F_{F1} at every 10 nm exhibits a unimodal shape within the range of wavelengths of 700 or more and less than 900 nm.

A light emitting device according to another aspect of the present invention includes the phosphor, and a solid-state light source that emits light in which an emission peak EP_{LS} of an emission spectrum E_{LS} is present on a shorter wavelength side of a fluorescence peak FP_{F1} of a fluorescence spectrum FL₁ of the phosphor.

A sensing system light source according to another aspect of the present invention includes the light emitting device.

A sensing system illumination system according to another aspect of the present invention includes the light emitting device.

### BRIEF DESCRIPTION OF DRAWINGS

[Fig. 1] Fig. 1 is a schematic cross-sectional view illustrating an example of a light emitting device according to a first embodiment.
[Fig. 2] Fig. 2 is a schematic cross-sectional view illustrating an example of a light emitting device according to a second embodiment.
[Fig. 3] Fig. 3 is a schematic cross-sectional view illustrating an example of a light emitting device according to a third embodiment.
[Fig. 4] Fig. 4 is a schematic cross-sectional view illustrating an example of a light emitting device according to a fourth embodiment.
[Fig. 5] Fig. 5 is a diagram illustrating an example of a sensing system according to the first embodiment.
[Fig. 6] Fig. 6 is a diagram illustrating an example of a sensing system according to the second embodiment.
[Fig. 7] Fig. 7 is a graph illustrating an example of a light receiving sensitivity curve LR of a CMOS image sensor included in a general CMOS camera.
[Fig. 8] Fig. 8 is a graph illustrating an example of an emission spectrum of a solid-state light source using a conventional phosphor.
[Fig. 9] Fig. 9 is a graph illustrating a fluorescence spectrum of a phosphor according to an example.
[Fig. 10] Fig. 10 is a graph illustrating an example of a fluorescence spectrum and of a unimodal fluorescence spectrum data group FD.
[Fig. 11] Fig. 11 is a graph illustrating a light receiving sensitivity curve LR of a general CMOS image sensor and an example of emission spectra of various white light emitting devices.
[Fig. 12] Fig. 12 is a graph illustrating fluorescence spectra of a phosphor according to example 1 and a conventional phosphor, and an excitation spectrum of the conventional phosphor.
[Fig. 13] Fig. 13 is a graph illustrating excitation spectra of the phosphor according to example 1 and the conventional phosphor, and a fluorescence spectrum of the conventional phosphor.
[Fig. 14] Fig. 14 is a graph illustrating a light receiving sensitivity curve LR of a general CMOS image sensor and an example of fluorescence spectra of various phosphors.

### DESCRIPTION OF EMBODIMENTS

A phosphor and a light emitting device according to embodiments are described in detail below with reference to the drawings. A sensing system including a sensing system light source and a sensing system illumination system according to embodiments will be described with reference to the drawings. Note that dimensional ratios in the drawings are exaggerated for convenience of the explanation and may differ from the actual ratios.

### <Light emitting device>

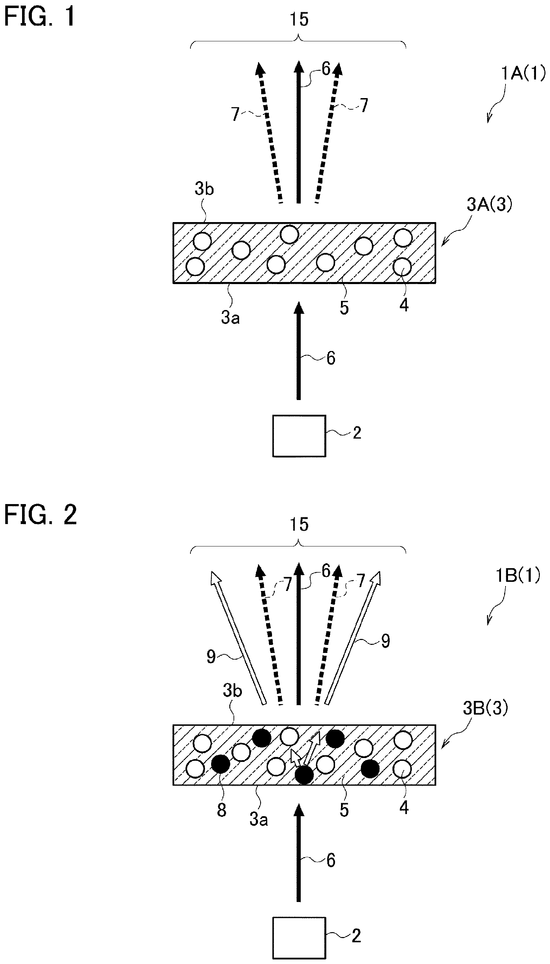

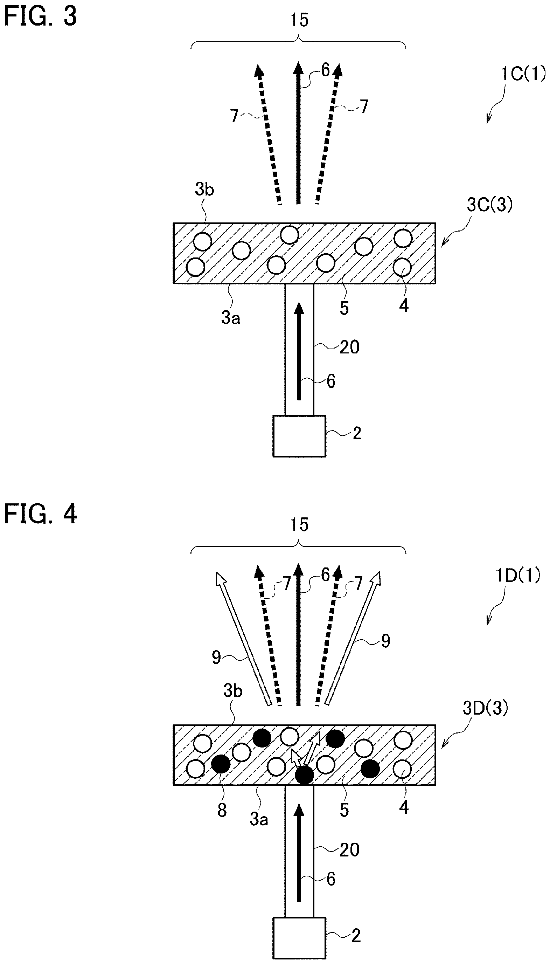

Light emitting devices 1 (1A to 1D) according to embodiments are illustrated in Figs. 1 to 4. Fig. 1 is a schematic cross-sectional view illustrating an example of a light emitting device according to a first embodiment. Fig. 2 is a schematic cross-sectional view illustrating an example of a light emitting device according to a second embodiment. Fig. 3 is a schematic cross-sectional view illustrating an example of a light emitting device according to a third embodiment. Fig. 4 is a schematic cross-sectional view illustrating an example of a light emitting device according to a fourth embodiment.

Note that the light emitting devices 1C and 1D according to the third and fourth embodiments respectively have the same configurations as the light emitting devices 1A and 1B according to the first and second embodiments apart from further including a light guide body 20 that guides primary light 6.

The light emitting devices 1A to 1D according to the first to fourth embodiments each include in common a solid-state light source 2 that emits the primary light 6, and a wavelength converter 3 that includes a first phosphor 4 which absorbs the primary light 6 and emits first wavelength-converted light 7. Thus, the light emitting devices 1A to 1D according to the first to fourth embodiments each emit output light 15 including the first wavelength-converted light 7.

In the light emitting devices 1A to 1D according to the first to fourth embodiments, when the primary light 6 emitted from the solid-state light source 2 enters the wavelength converter 3, a phosphor such as the first phosphor 4 included in the wavelength converter 3 emits fluorescence. The first phosphor 4 emits the first wavelength-converted light 7 when receiving the primary light 6.

Note that the wavelength converter 3 (3A to 3D) of the light emitting devices 1A to 1D illustrated in Figs. 1 to 4 is configured to receive the primary light 6 at a front surface 3a and to emit the first wavelength-converted light 7 from a back surface 3b.

Note that the wavelength converter 3 (3A to 3D) according to the light emitting devices 1A to 1D according to the first to fourth embodiments receives the primary light 6 and emits the output light 15 including at least the primary light 6 and the first wavelength-converted light 7. The light emitting devices 1A to 1D according to the first to fourth embodiments may be used in combination with a light source that emits white light.

### [First embodiment]

A light emitting device 1A (1) according to the first embodiment will be described. The light emitting device 1A according to the first embodiment includes the solid-state light source 2 and the wavelength converter 3 (3A).

In the light emitting device 1A, the solid-state light source 2 and the wavelength converter 3A are arranged spaced apart, and this can cause a subject to be irradiated, with a high degree of freedom, with output light 15 including first wavelength-converted light 7 emitted from the wavelength converter 3A.

### (Solid-state light source)

The solid-state light source 2 emits primary light 6. Light having a high emission intensity is used as the primary light 6. As the light having a high emission intensity, for example, laser light, light radiated from a high power LED, or the like is used. As the primary light 6, light containing blue light having a spectral distribution maximum intensity within a wavelength range of 400 or more and less than 500 nm is used, for example. As the blue light, light having a spectral distribution maximum intensity within a wavelength range of 420 or more and less than 480 nm is preferably used.

As the solid-state light source 2, a solid-state light emitting element is used, for example. It is preferable that the solid-state light source 2 be a solid-state light emitting element because of its excellent durability and long life. As the solid-state light source 2, a solid-state light emitting element such as an LED or a laser element is used.

The solid-state light source 2 emits light in which an emission spectrum E_{LS} has an emission peak EP_{LS} present on the shorter wavelength side of a fluorescence peak FP_{F1} of a fluorescence spectrum FL₁ of the first phosphor included in the wavelength converter 3A (3).

### (Wavelength converter)

The wavelength converter 3 (3A) includes the first phosphor 4 and a sealant 5. In the wavelength converter 3A, the first phosphor 4 is included in the sealant 5.

### <First phosphor>

The first phosphor 4 is a phosphor that contains Cr³⁺ and emits near-infrared light, and is a phosphor that absorbs primary light 6 and converts it into first wavelength-converted light 7 having a longer wavelength than that of the primary light 6. As described below, in the first wavelength-converted light 7, a fluorescence spectrum F_{F1} has a fluorescence peak FP_{F1} within a range of wavelengths of 700 or more and less than 900 nm. In addition, in the first wavelength-converted light 7, a fluorescence spectrum data group FD is an aggregate of spectral intensities of the fluorescence spectrum F_{F1} at every 10 nm and exhibits a unimodal shape within a range of wavelengths of 700 or more and less than 900 nm, as described below.

The host crystal of the first phosphor 4 has the same crystal structure as the compound Mg₃Ga₂GeO₈. Cr³⁺ contained in the first phosphor 4 is present in the host crystal through replacing part of the elements that constitute the host crystal having the same crystal structure as that of the compound Mg₃Ga₂GeO₈.

Here, the same crystal structure as that of the compound Mg₃Ga₂GeO₈ means the same crystal structure as that of Mg₃Ga₂GeO₈ having a (Ga/Mg)O₆ octahedral structure and a (Ga/Ge)O₄ tetrahedral structure. The (Ga/Mg)O₆ octahedral structure is an octahedral structure centered on Ga or Mg with six O atoms bonded to the Ga or Mg. The (Ga/Ge)O₄ tetrahedral structure is a tetrahedral structure centered on Ga or Ge with four O atoms bonded to the Ga or Ge.

In the first phosphor 4, the (Ga/Mg)O₆ octahedral structure and the (Ga/Ge)O₄ tetrahedral structure, which make up the host crystal, have one or more sites of Ga, Mg, and Ge replaced with Cr³⁺.

In the first phosphor 4, the fluorescence spectrum F_{F1} has the fluorescence peak FP_{F1} within a range of wavelengths of 700 or more and less than 900 nm. In the first phosphor 4, the fluorescence spectrum F_{F1} has the fluorescence peak FP_{F1} preferably within a range of wavelengths of 730 or more and less than 880 nm, more preferably within a range of wavelengths of 750 or more and less than 850 nm.

It is preferable that the fluorescence spectrum F_{F1} of the first phosphor 4 have the fluorescence peak FP_{F1} within the above-mentioned wavelength ranges because the first phosphor 4 emits only light in the near-infrared range suitable for acquiring vital information, such as information about blood pressure, pulse waves, and blood vessels deep in a living body.

It is not preferable that the fluorescence spectrum F_{F1} of the first phosphor 4 have the fluorescence peak FP_{F1} within a range of wavelengths from 900 nm or more because light energy is easily wasted by emitting light in a wavelength range where the light receiving sensitivity of a general CMOS image sensor is very low.

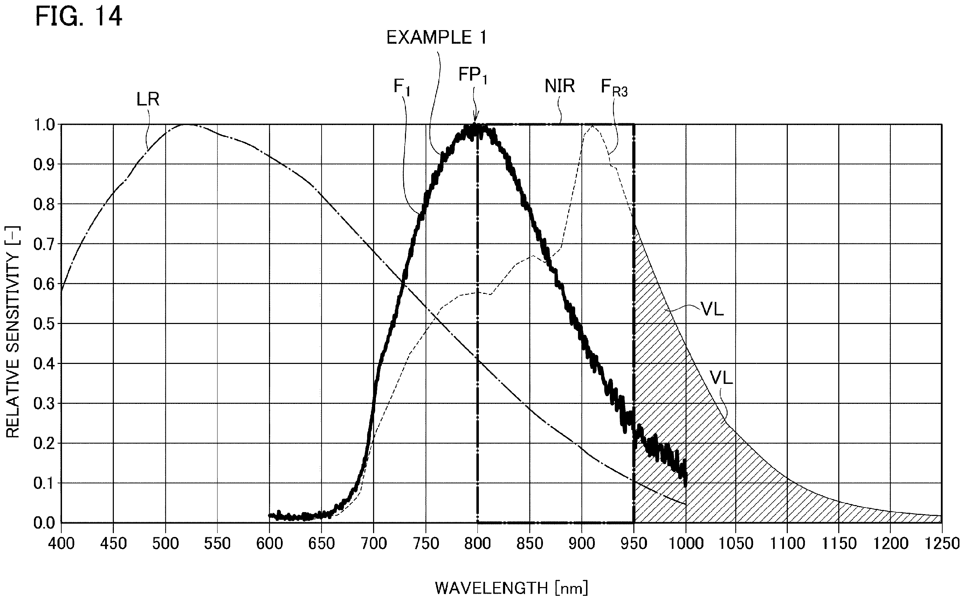

This point will be described with reference to Fig. 14. Fig. 14 is a graph illustrating a light receiving sensitivity curve LR of a general CMOS image sensor and an example of fluorescence spectra of various phosphors. Fig. 14 illustrates the light receiving sensitivity curve LR of a CMOS image sensor included in a general CMOS camera. Note that the wavelength range of 950 nm or more is a range with a particularly low light receiving sensitivity of a CMOS image sensor included in a general CMOS camera.

In addition, Fig. 14 illustrates a fluorescence spectrum F₁ of a phosphor of example 1 described below, which has the fluorescence peak FP_{F1} within a range of wavelengths of 700 or more and less than 900 nm, specifically at a wavelength of 800 nm. Furthermore, Fig. 14 illustrates a fluorescence spectrum F_{R3} of a conventional phosphor (hereinafter also referred to as "R3 phosphor") having a fluorescence peak FP_{R3} within a range of 900 nm or more, specifically at a wavelength of 915 nm.

As illustrated in the light receiving sensitivity curve LR, regarding the light receiving sensitivity of a CMOS image sensor included in a general CMOS camera, the relative sensitivity in the near-infrared range NIR at wavelengths from 800 to 950 nm is low and is about 40 to 5% compared to the case of a peak around 520 nm. Note that in the near-infrared range at wavelengths from 800 to 950 nm, the above-mentioned relative sensitivity is about 40 to 10%.

In contrast, the fluorescence spectrum F₁ of the phosphor of example 1 and the fluorescence spectrum F_{R3} of the R3 phosphor have large fluorescence intensities in the near-infrared range NIR at wavelengths from 800 to 950 nm. Thus, when the phosphor of example 1 and the R3 phosphor are used in a light emitting device, it is possible to obtain high-quality image data 170 even when a CMOS camera including a CMOS image sensor having a low light receiving sensitivity in the near-infrared range NIR is used.

Note that the fluorescence intensity of the fluorescence spectrum F_{R3} of the R3 phosphor decreases as the wavelength becomes longer from the fluorescence peak FP_{R3} at the wavelength of 915 nm, but the fluorescence intensity is about 75% with respect to the fluorescence peak FP_{R3} even at the wavelength of 950 nm and is still high. Thus, when the R3 phosphor is used in a light emitting device, a large amount of light energy will be wastefully supplied at the wavelength range of 950 nm or more, which is particularly low in light receiving sensitivity of the CMOS image sensor, resulting in low energy efficiency.

In Fig. 14, VL indicates a region in the fluorescence spectrum F_{R3} of the R3 phosphor where light energy is likely to be wasted because it is in the wavelength range of 950 nm or more, which is particularly low in light receiving sensitivity of the CMOS image sensor. The area of the region VL is about 35% of the light energy in the wavelength range of 800 nm or more in the fluorescence spectrum F_{R3} of the R3 phosphor, indicating that the loss of light energy is considerably large in the range with particularly low light receiving sensitivity of the CMOS image sensor.

In contrast, the fluorescence intensity of the fluorescence spectrum F₁ of the phosphor of example 1 decreases as the wavelength becomes longer than the fluorescence peak FP_{F1} at the wavelength of 800 nm, and has decreased to about 23% at the wavelength of 950 nm with respect to the fluorescence peak FP_{F1}. The area of the region VL of the phosphor of example 1 is about 8% of the light energy at the wavelength of 800 nm or more of the fluorescence spectrum F₁ of the phosphor of example 1, indicating that the loss of light energy is small in the range with particularly low light receiving sensitivity of the CMOS image sensor. Thus, when the phosphor of example 1 is used in a light emitting device, light energy is not wastefully supplied to the wavelength range of 950 nm or more, which is particularly low in light receiving sensitivity of the CMOS image sensor, resulting in high energy efficiency.

In the first phosphor 4, the fluorescence spectrum data group FD, which is an aggregate of spectral intensities at every 10 nm of the fluorescence spectrum F_{F1}, exhibits a unimodal shape within a range of wavelengths of 700 or more and less than 900 nm. The fluorescence spectrum data group FD is, in other words, an aggregate of histogram vertex values, which is an aggregate of spectral intensities of the fluorescence spectrum F_{F1} at every 10 nm.

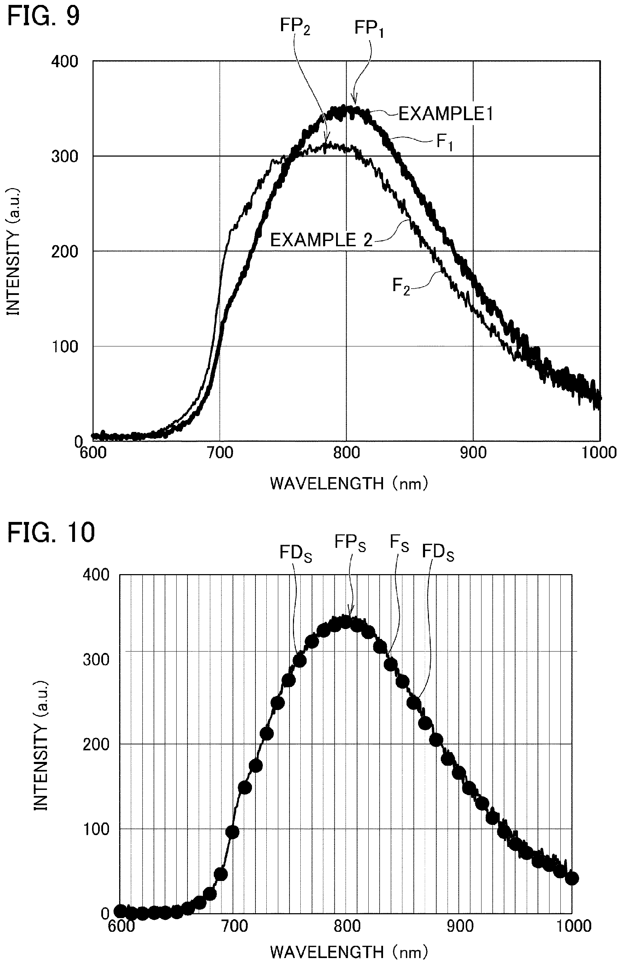

Using drawings, "the fluorescence spectrum data group FD, which is an aggregate of spectral intensities of the fluorescence spectrum F_{F1} at every 10 nm, exhibits a unimodal shape" will be described. Fig. 10 is a graph illustrating an example of a fluorescence spectrum and of the unimodal fluorescence spectrum data group FD. Specifically, Fig. 10 is a graph illustrating an example of a fluorescence spectrum F_{S} of a measured sample S and of a unimodal fluorescence spectrum data group FD_{S} generated from the fluorescence spectrum F_{S}.

As illustrated in Fig. 10, the fluorescence spectrum F_{S} is a graph of a unimodal continuous curve having one fluorescence peak FP_{S}. Here, unimodal means a shape having a distribution curve of one peak. The fluorescence spectrum data group FD_{S} illustrated in Fig. 10 is a graph of an intermittent curve, which is an aggregate of spectral intensities of the fluorescence spectrum F_{S} at every 10 nm. Specifically, the fluorescence spectrum data group FD_{S} illustrated in Fig. 10 is an aggregate of data of spectral intensities of the fluorescence spectrum F_{S} at measurement points at every 10 nm, such as 790 nm, 800 nm, and 810 nm.

As illustrated in Fig. 10, the fluorescence spectrum data group FDs exhibits a shape in which the aggregate of data of spectral intensities at measurement points at every 10 nm has a distribution curve of one peak within a range of wavelengths of 700 or more and less than 900 nm. Thus, the fluorescence spectrum data group FDs of the fluorescence spectrum F_{S} illustrated in Fig. 10 exhibits a unimodal shape within a range of wavelengths of 700 or more and less than 900 nm.

In addition, in the first phosphor 4, the fluorescence spectrum data group FD preferably exhibits a unimodal shape within a range of wavelengths of 650 or more and less than 950 nm. Furthermore, in the first phosphor 4, the fluorescence spectrum data group FD more preferably exhibits a unimodal shape within a range of wavelengths of 700 or more and less than 900 nm.

When the fluorescence spectrum data group FD of the first phosphor 4 exhibits a unimodal shape, the first phosphor 4 is preferred as a light source for applications using a detection signal of a detector through Fourier transform.

When the fluorescence spectrum data group FD of the first phosphor 4 exhibits a unimodal shape having a shape close to the normal distribution, the generation of a false signal after Fourier transform can be suppressed when the near-infrared radiation emitted by the first phosphor 4 is detected and the detection signal is subjected to Fourier transform. Thus, it is preferable that the fluorescence spectrum data group FD of the first phosphor 4 exhibit a unimodal shape having a shape close to the normal distribution because it results in a light emitting device advantageous in causing a detector to detect a detection signal having excellent quality as a signal.

Whether the fluorescence spectrum data group FD of the first phosphor 4 exhibits a unimodal shape having a shape close to the normal distribution is determined using the following conditions, for example. Specifically, a wavelength at which the fluorescence spectrum data group FD exhibits the maximum intensity value is defined as λP, and wavelengths on the short and long wavelength sides at which the intensity of the fluorescence spectrum data group FD is half the maximum intensity value are defined as λS and λL, respectively. Here, a unimodal shape close to the normal distribution is a spectral distribution in which, for example, values of λP, λS, and λL are such that 1 ≤ (λL-λP) / (λP-λS) < 2.0, preferably 1 ≤ (λL-λP) / (λP-λS) < 1.8.

In the first phosphor 4, the half width of the fluorescence peak FP_{F1} is usually 120 or more and less than 200 nm, preferably 145 or more and less than 190 nm, more preferably 165 or more and less than 185 nm. Here, the half width of the fluorescence peak FP_{F1} is the full width at half maximum of the fluorescence peak FP_{F1}. An example of the half width of the fluorescence peak FP_{F1} is illustrated in Fig. 12.

Fig. 12 is a graph illustrating fluorescence spectra of a phosphor according to example 1 and a conventional phosphor, and an excitation spectrum of the conventional phosphor. Specifically, Fig. 12 is a graph illustrating fluorescence spectra F₁ and F_{P2} of the phosphor according to example 1 described below and the Mg₃Ga₂GeO₈ phosphor disclosed in Non-Patent Literature 1, and an excitation spectrum X_{P2} of the above Mg₃Ga₂GeO₈ phosphor. The Mg₃Ga₂GeO₈ phosphor disclosed in Non-Patent Literature 1 is also referred to as "P2 phosphor" hereinafter. Here, the fluorescence spectra F₁ and F_{P2} are fluorescence spectra at an excitation wavelength of λₑₓ = 425 nm. The excitation spectrum X_{P2} is an excitation spectrum at a fluorescence wavelength of λₑₘ = 915 nm.

In Fig. 12, the half widths of the fluorescence spectra F₁ and F_{P2} are HW₁ and HW_{P2}, respectively. Specifically, the half width HW₁ of the fluorescence spectrum F₁ is 174 nm, and the half width HW_{P2} of the fluorescence spectrum F_{P2} is 232 nm.

As illustrated in Fig. 12, the fluorescence spectrum F₁ of the phosphor according to example 1 has the half width HW₁ of 174 nm and is within the range of 120 or more and less than 200 nm. In contrast, the fluorescence spectrum F_{P2} of the P2 phosphor has a half width HW_{P2} of 232 nm and is 200 nm or more.

It is preferable that the first phosphor 4 have the half width of the fluorescence peak FP_{F1} within the above-mentioned ranges because the fluorescence peak FP_{F1} can widely cover the long wavelength range where a general image sensor has a high sensitivity. Note that when the half width of the fluorescence peak FP_{F1} of the first phosphor 4 is 200 nm or more, the fluorescence peak FP_{F1} spreads to a wavelength range where a general image sensor has a low sensitivity, and this may reduce light utilization efficiency.

In the first phosphor 4, an excitation spectrum X_{F1} exhibits a multimodal shape usually within a range of wavelengths of 370 or more and less than 700 nm, preferably 385 or more and less than 680 nm (hereinafter also referred to as "VR wavelength range"). Here, multimodal means a shape with a distribution curve of two or more peaks.

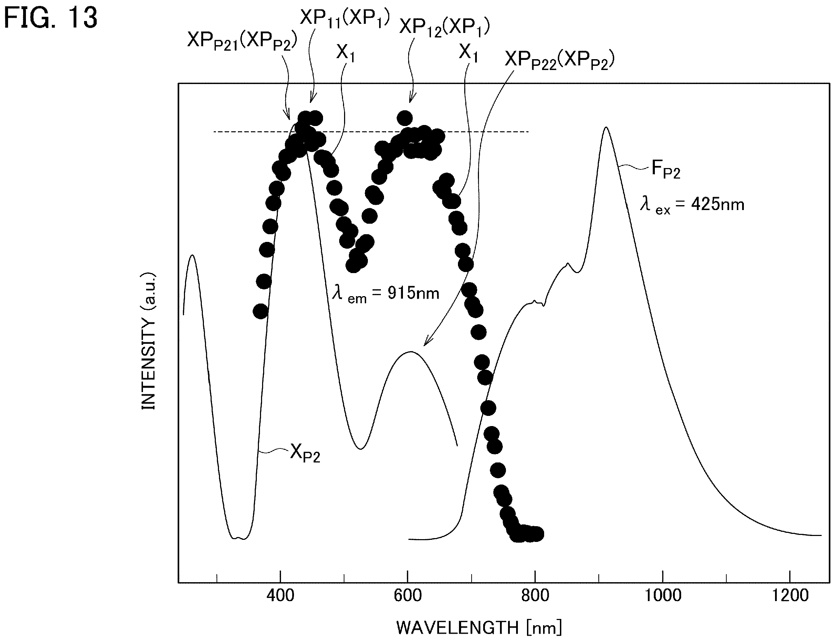

Using drawings, "the excitation spectrum X_{F1} exhibits a multimodal shape" will be described. Fig. 13 is a graph illustrating excitation spectra of the phosphor according to example 1 and the conventional phosphor, and a fluorescence spectrum of the conventional phosphor. Specifically, Fig. 13 is a graph illustrating excitation spectra X₁ and X_{P2} of the phosphor according to example 1 and the Mg₃Ga₂GeO₈ phosphor (P2 phosphor) disclosed in Non-Patent Literature 1, and a fluorescence spectrum F_{P2} of the above Mg₃Ga₂GeO₈ phosphor. Here, the excitation spectra X₁ and X_{P2} are excitation spectra at a fluorescence wavelength of λₑₘ = 915 nm. The fluorescence spectrum F_{P2} is a fluorescence spectrum at an excitation wavelength of λₑₓ = 425 nm.

As illustrated in Fig. 13, the excitation spectrum X₁ of the phosphor according to example 1 exhibits a graph of an intermittent curve having two excitation peaks, XP₁₁ (XP₁, 440 nm) and XP₁₂ (XP₁, 595 nm). Note that the excitation spectrum X₁ is an aggregate of data at measurement points at every 5 nm, and thus it is an intermittent curve.

The excitation spectrum X₁ of the phosphor according to example 1 has a shape with a distribution curve of two peaks, having two excitation peaks XP₁₁ and XP₁₂ within a range of wavelengths of 370 or more and less than 700 nm. Thus, the excitation spectrum X₁ of the phosphor according to example 1 exhibits a multimodal shape within a range of wavelengths of 370 or more and less than 700 nm.

Note that the two excitation peaks XP₁₁ and XP₁₂ of the excitation spectrum X₁ of the phosphor according to example 1 have almost the same peak height. Thus, using the phosphor according to example 1 makes it possible to perform efficient excitation using the light in the vicinity of the two excitation peaks XP₁₁ and XP₁₂, and increases the degree of freedom in designing a solid-state light source including the phosphor.

In contrast, the excitation spectrum X_{P2} of the P2 phosphor exhibits a graph of a continuous curve having two excitation peaks XP_{P21} (XP_{P2}, 425 nm) and XP_{P22} (XP_{P2}, 605 nm). The excitation spectrum X_{P2} of the P2 phosphor has a shape with a distribution curve of two peaks, having two excitation peaks XP_{P21} and XP_{P22} within a range of wavelengths of 370 or more less than 700 nm. Thus, the excitation spectrum X_{P2} of the P2 phosphor exhibits a multimodal shape within a range of wavelengths of 370 or more and less than 700 nm.

Note that the two excitation peaks XP_{P21} and XP_{P22} of the excitation spectrum X_{P2} of the P2 phosphor differ greatly in peak height. Thus, using the P2 phosphor makes it possible to perform efficient excitation using only light in the vicinity of one excitation peak XP_{P21}, and reduces the degree of freedom in designing a solid-state light source including the phosphor.

In the first phosphor 4, when the maximum intensity value of a blue-side spectral portion X_{BS} is M_{BS} and the maximum intensity value of a red-side spectral portion X_{RS} is M_{RS} in the excitation spectrum X_{F1}, a maximum intensity ratio M_{RS}/M_{BS} obtained by dividing M_{RS} by M_{BS} is usually 70% or more. Here, the blue-side spectral portion X_{BS} means a portion within a blue-side range of wavelengths of 370 or more and less than 520 nm. The red-side spectral portion X_{RS} means a portion within a red-side range of wavelengths 520 or more and less than 700 nm.

The first phosphor 4 has the maximum intensity ratio M_{RS}/M_{BS} of preferably 75% or more, more preferably 80% or more. When the maximum intensity ratio M_{RS}/M_{BS} is within the above-mentioned ranges, the first phosphor 4 has a higher ratio of excitation based on the red-side spectral portion X_{RS} compared to the conventional phosphor having a higher ratio of excitation based on the blue-side spectral portion Xas. Thus, for the first phosphor 4 having the maximum intensity ratio M_{RS}/M_{BS} within the above-mentioned ranges, it becomes possible to be excited by long-wavelength light present in or near the red-side spectral portion X_{RS} to emit near-infrared light. Hence, for the first phosphor 4 having the maximum intensity ratio M_{RS}/M_{BS} within the above-mentioned ranges, it is possible to reduce Stokes loss compared with the case of being excited by short-wavelength light present in or near the blue-side spectral portion X_{BS} to emit near-infrared light.

In the excitation spectrum X₁ of the phosphor according to example 1 illustrated in Fig. 13, the maximum intensity value M_{BS} of the excitation peak XP₁₁ in the blue-side range and the maximum intensity value M_{RS} of the excitation peak XP₁₂ in the red-side range are almost the same. Thus, in the first phosphor 4 according to example 1, the maximum intensity ratio M_{RS}/M_{BS} is almost 100%, and the requirement that the maximum intensity ratio M_{RS}/M_{BS} is 70% or more is satisfied. Thus, it is possible for a phosphor according to example 1 to reduce Stokes loss when being excited by long-wavelength light present in or near the red-side spectral portion X_{RS} to emit near-infrared light.

In contrast, in the excitation spectrum X_{P2} of the Mg₃Ga₂GeO₈ phosphor disclosed in Non-Patent Literature 1 illustrated in Fig. 13, the maximum intensity value M_{RS} of the excitation peak XP_{P22} in the red-side range is about 50% compared with the maximum intensity value M_{BS} of the excitation peak XP_{P21} in the blue-side range. Thus, in the P2 phosphor, the maximum intensity ratio M_{RS}/M_{BS} is about 50% and is less than 70%. Thus, for the P2 phosphor, it is not efficient to be excited using long-wavelength light present in or near the red-side spectral portion X_{RS}, and consequently, it is difficult to reduce Stokes loss when emitting near-infrared light.

As described above, the first phosphor 4 is a phosphor in which the host crystal has the same crystal structure as the compound Mg₃Ga₂GeO₈, and which contains Cr³⁺ and emits near-infrared light.

In the first phosphor 4, the host crystal is represented by formula (1) below and a part thereof is replaced with Cr, for example.

M^{II}ₐM^{XIII}_{b}M^{XIV}_{c}O_{d} (1)

(In the formula, M^{II} is a bivalent element, M^{XIII} is a group 13 element, M^{XIV} is a group 14 element, 'a' is 2.7 to 3.3, 'b' is 1.2 to 2.8, 'c' is 0.8 to 1.2, and 'd' is 7.2 to 8.8.)

The host crystal represented by formula (1) includes a (M^{XIII}/M^{II})O₆ octahedral structure and a (M^{XIII}/M^{XIV})O₄ tetrahedral structure, and has a crystal structure of Mg₃Ga₂GeO₈.

In formula (1), it is preferable that M^{II} contain Mg, M^{XIII} contain Ga, and M^{XIV} contain Ge. When M^{II} contains Mg, M^{XIII} contains Ga, and M^{XIV} contains Ge in formula (1), a host crystal represented by formula (1) is close to the crystal structure of the compound Mg₃Ga₂GeO₈.

Specifically, when M^{II} contains Mg, M^{XIII} contains Ga, and M^{XIV} contains Ge in formula (1), the (M^{XIII}/M^{II})O₆ octahedral structure is close to the (Ga/Mg)O₆ octahedral structure of the compound Mg₃Ga₂GeO₈. Also, when M^{II} contains Mg, M^{XIII} contains Ga, and M^{XIV} contains Ge in formula (1), the (M^{XIII}/M^{XIV})O₄ tetrahedral structure is close to the (Ga/Ge)O₄ tetrahedral structure of the compound Mg₃Ga₂GeO₈.

### <Sealant>

In the wavelength converter 3, the first phosphor 4 is included in the sealant 5. Preferably, the first phosphor 4 is dispersed in the sealant 5. When the first phosphor 4 is dispersed in the sealant 5, it becomes possible to efficiently absorb the primary light 6 emitted by the solid-state light source 2 and efficiently convert the wavelength thereof to that of near-infrared light. When the first phosphor 4 is dispersed in the sealant 5, it becomes easier to form the wavelength converter 3 into a sheet or film shape.

The sealant 5 is made from at least one of an organic material or an inorganic material. The sealant 5 is preferably made from at least one of a transparent (translucent) organic material or a transparent (translucent) inorganic material. An example of the organic material sealant is a transparent organic material, such as silicone resin. An example of the inorganic material sealant is a transparent inorganic material, such as low melting point glass.

Note that the wavelength converter 3 is preferably made from an inorganic material. An inorganic material here means a material other than an organic material, and includes ceramics and metals as a concept. When the wavelength converter 3 is made from an inorganic material, the thermal conductivity thereof is higher than that of the wavelength converter containing an organic material such as a sealing resin, and this facilitates the heat dissipation design. Thus, even when the first phosphor 4 is photoexcited at high density by the primary light 6 emitted from the solid-state light source 2, the temperature rise of the wavelength converter 3 can be effectively suppressed. Consequently, the temperature quenching of the first phosphor 4 in the wavelength converter 3 is suppressed, and it becomes possible to achieve high output of emitted light.

When the wavelength converter 3 is made from an inorganic material, the sealant 5 is preferably made from an inorganic material. The inorganic material for the sealant 5 is preferably zinc oxide (ZnO). When the sealant 5 is made from an inorganic material, the heat dissipation of the first phosphor 4 is further enhanced and thus a decrease in output of the first phosphor 4 due to temperature quenching is suppressed, and this makes it possible to emit high-output near-infrared light.

Note that as a modified example of the light emitting device 1A, a wavelength converter without the sealant 5 can be used instead of the wavelength converter 3. In this case, it is sufficient that particles of the first phosphor 4 be fixed to each other using an organic or inorganic binder. Particles of the first phosphor 4 can also be fixed to each other through a heating reaction of the first phosphor 4. A generally used resin-based adhesive, ceramic fine particles, low-melting-point glass, or the like can be used as the binder. With a wavelength converter without the sealant 5, the thickness of the wavelength converter can be reduced.

### (Action)

The action of the light emitting device 1A will be described. As illustrated in Fig. 1, first, the primary light 6 emitted from the solid-state light source 2 is emitted on a front surface 3a of the wavelength converter 3A. The emitted primary light 6 penetrates the wavelength converter 3A. When the primary light 6 penetrates the wavelength converter 3A, the first phosphor 4 included in the wavelength converter 3A absorbs part of the primary light 6 and emits the first wavelength-converted light 7. In this way, the output light 15 including the primary light 6 and the first wavelength-converted light 7 is emitted from a back surface 3b of the wavelength converter 3A.

### (Effect)

The first phosphor 4 included in the wavelength converter 3A of the light emitting device 1A emits first wavelength-converted light 7 containing a large amount of a near-infrared light component, and thus the wavelength converter 3A of the light emitting device 1A emits output light 15 containing a large amount of the near-infrared light component.

Therefore, by irradiating a subject 110 with the output light 15 of the light emitting device 1A, even when a camera 150 using a CMOS image sensor having a low light receiving sensitivity in the near-infrared range is used, high-quality image data 170 with the near-infrared range compensated can be obtained. Thus, the light emitting device 1A can provide a phosphor and a light emitting device that have a high fluorescence intensity in the near-infrared range (wavelength 800 to 950 nm).

In addition, the light emitting device 1A can be used for a sensing system light source 300A and a sensing system illumination system 100A described below.

Thus, the light emitting device 1A can provide a sensing system light source and a sensing system illumination system that have a high fluorescence intensity in the near-infrared range (wavelength 800 to 950 nm).

### [Second embodiment]

A light emitting device 1B (1) according to a second embodiment will be described. The light emitting device 1B according to the second embodiment includes the solid-state light source 2 and the wavelength converter 3 (3B). The light emitting device 1B according to the second embodiment uses the wavelength converter 3B instead of the wavelength converter 3A of the light emitting device 1A according to the first embodiment. In contrast to the wavelength converter 3A, the wavelength converter 3B further includes a second phosphor 8.

### (Wavelength converter)

The wavelength converter 3B includes the first phosphor 4, the second phosphor 8, and the sealant 5. In the wavelength converter 3B, the first phosphor 4 and the second phosphor 8 are included in the sealant 5. That is, the wavelength converter 3B of the light emitting device 1B further includes the second phosphor 8, and the second phosphor 8 absorbs the primary light 6 and converts it into second wavelength-converted light 9 different from the first wavelength-converted light 7.

That is, the wavelength converter 3B includes the first phosphor 4 and further includes the second phosphor 8 in which a fluorescence peak FP_{F2} of a fluorescence spectrum F_{F2} is present on the shorter wavelength side of the fluorescence peak FP_{F1} of the fluorescence spectrum F_{F1} of the first phosphor 4.

The wavelength converter 3B is the same as the wavelength converter 3A of the light emitting device 1 according to the first embodiment except that it further includes the second phosphor 8. Thus, the second phosphor 8 is mainly described below, and the description of other configurations and operations is omitted or simplified.

### <Second phosphor>

The second phosphor 8 is a phosphor in which the fluorescence peak FP_{F2} of the fluorescence spectrum F_{F2} is present on the shorter wavelength side of the fluorescence peak FP_{F1} of the fluorescence spectrum F_{F1} of the first phosphor 4. Specifically, the second phosphor 8 is a phosphor in which the fluorescence peak FP_{F2} of the fluorescence spectrum F_{F2} of the second wavelength-converted light 9 is present on the shorter wavelength side of the fluorescence peak FP_{F1} of the fluorescence spectrum F_{F1} of the first wavelength-converted light 7 of the first phosphor 4.

In the light emitting device 1B, the wavelength converter 3B further includes the second phosphor 8 in addition to the first phosphor 4, and thus it is possible to emit visible radiation, for example white output light 15.

As described above, when the wavelength converter 3B further includes the second phosphor 8 in addition to the first phosphor 4, the shape and excitation characteristics of the fluorescence spectrum emitted from the wavelength converter 3B can be controlled. Thus, it becomes possible for the obtained light emitting device 1B to easily adjust the spectral distribution of the output light according to the application.

The second phosphor 8 is not particularly limited as long as the fluorescence peak FP_{F2} of the fluorescence spectrum F_{F2} of the second wavelength-converted light 9 is present on the shorter wavelength side of the fluorescence peak FP_{F1} of the fluorescence spectrum F_{F1} of the first wavelength-converted light 7 of the first phosphor 4.

The second phosphor 8 preferably contains a phosphor of a garnet crystal structure containing Ce³⁺. It is preferable that the second phosphor 8 contain a phosphor of a garnet crystal structure containing Ce³⁺ because it has an emission peak wavelength from 500 to 600 nm, resulting in broad emission in a wide band.

As the phosphor of a garnet crystal structure containing Ce³⁺, for example, Y₃Al₅O₁₂:Ce³⁺, Y₃(Al,Ga)₅O₁₂:Ce³⁺, Lu₃Al₅O₁₂:Ce³⁺, Lu₂CaMg₂Si₃O₁₂:Ce³⁺, or the like is used. When a second phosphor 8 containing such a phosphor of a garnet crystal structure containing Ce³⁺ is used, it becomes possible to obtain output light having a large amount of light components from green-based to yellow-based light components.

Such a second phosphor 8 absorbs light well within a wavelength range of 430 or more and 480 nm or less to convert it with high efficiency to green-based to yellow-based light having the maximum intensity value within a wavelength range of 500 or more less than 600 nm. Thus, it becomes possible to easily obtain visible light components by having a solid-state light source 2 that emits blue light as the primary light 6 and then using the second phosphor 8.

When the wavelength converter 3B includes the first phosphor 4 and the second phosphor 8, it is preferable that the first phosphor 4 emit the first wavelength-converted light 7 by absorbing at least one of the primary light 6 emitted by the solid-state light source 2 or the second wavelength-converted light 9 emitted by the second phosphor 8. As described above, it is preferable that the first phosphor 4 be a phosphor that absorbs the primary light 6 emitted by the solid-state light source 2 and emits the first wavelength-converted light 7, which is near-infrared light.

The first phosphor 4 may be a phosphor that absorbs the second wavelength-converted light 9 emitted by the second phosphor 8 and emits the first wavelength-converted light 7, which is near-infrared light. That is, the second phosphor 8 may be excited by the primary light 6 to emit the second wavelength-converted light 9, and the first phosphor 4 may be excited by the second wavelength-converted light 9 to emit the first wavelength-converted light 7. In this case, even when the first phosphor 4 is a phosphor that is hardly excited by the primary light 6, by means of the second phosphor 8, it becomes possible for the first phosphor 4 to be excited by the fluorescence emitted by the second phosphor 8.

Therefore, when the first phosphor 4 absorbs the second wavelength-converted light 9 and emits the first wavelength-converted light 7, it becomes possible to select as the first phosphor 4 a phosphor that absorbs the visible light, and this broadens the choice of the first phosphor 4 and facilitates the industrial production of the light emitting device 1B. In addition, when the first phosphor 4 absorbs the second wavelength-converted light 9 and emits the first wavelength-converted light 7, it becomes possible for the light emitting device 1B to emit first wavelength-converted light 7 having a large near-infrared light component intensity.

Note that the second phosphor 8 may contain a phosphor of a garnet crystal structure containing two or more types of Ce³⁺. When the second phosphor 8 contains two or more types of Cr³⁺-activated phosphor, the output light component at least in the near-infrared wavelength range can be controlled, and this facilitates the adjustment of the spectral distribution of the near-infrared fluorescent component.

### (Action)

The action of the light emitting device 1B will be described. As illustrated in Fig. 2, first, the primary light 6 emitted from the solid-state light source 2 is emitted on the front surface 3a of the wavelength converter 3B. The emitted primary light 6 penetrates the wavelength converter 3B. Then, when the primary light 6 penetrates the wavelength converter 3B, the second phosphor 8 included in the wavelength converter 3B absorbs part of the primary light 6 and emits the second wavelength-converted light 9. Furthermore, the first phosphor 4 included in the wavelength converter 3B absorbs part of the primary light 6 and/or part of the second wavelength-converted light 9 and emits the first wavelength-converted light 7. In this way, the output light 15 including the primary light 6, the first wavelength-converted light 7, and the second wavelength-converted light 9 is emitted from the back surface 3b of the wavelength converter 3B.

### (Effect)

The first phosphor 4 included in the wavelength converter 3B of the light emitting device 1B emits the first wavelength-converted light 7 containing a large amount of the near-infrared light component, and thus the wavelength converter 3B of the light emitting device 1B emits the output light 15 containing a large amount of the near-infrared light component.

Therefore, the light emitting device 1B achieves the same effect as that of the light emitting device 1A according to the first embodiment.

In addition, since the wavelength converter 3B of the light emitting device 1B further includes the second phosphor 8, it becomes possible for the light emitting device 1B to easily adjust the spectral distribution of the output light according to the application.

### [Third embodiment]

A light emitting device 1C (1) according to a third embodiment will be described. The light emitting device 1C according to the third embodiment includes the solid-state light source 2, the wavelength converter 3 (3C), and a light guide body 20. The light emitting device 1C according to the third embodiment is obtained by adding the light guide body 20 to the light emitting device 1A according to the first embodiment.

The difference between the light emitting device 1C according to the third embodiment and the light emitting device 1A according to the first embodiment is only in the light guide body 20. Thus, the light guide body 20 is mainly described below, and the description of configurations and operations for other members is omitted or simplified.

In the light emitting device 1C, the solid-state light source 2 and the wavelength converter 3C are arranged spaced apart in such a manner that the primary light 6 emitted from the solid-state light source 2 passes through the inside of the light guide body 20 to be emitted on the wavelength converter 3C.

### (Light guide body)

The light guide body 20 is a member arranged between the solid-state light source 2 and the wavelength converter 3C to guide the primary light 6 to the wavelength converter 3C. The primary light 6 is to pass through the inside of the light guide body 20.

In the light emitting device 1C, the solid-state light source 2 and the wavelength converter 3C are arranged spaced apart. However, the light guide body 20 allows the primary light 6 emitted by the solid-state light source 2 to pass through the inside of the light guide body 20 to be emitted on the wavelength converter 3C. In the light emitting device 1C, by providing the light guide body 20, the primary light 6 can be efficiently guided to the wavelength converter 3C even when the solid-state light source 2 and the wavelength converter 3C are arranged spaced apart.

For example, an optical fiber or the like is used as the light guide body 20.

### (Action)

The action of the light emitting device 1C will be described. As illustrated in Fig. 3, first, the primary light 6 emitted from the solid-state light source 2 passes through the inside of the light guide body 20 to be emitted on the front surface 3a of the wavelength converter 3C. The emitted primary light 6 penetrates the wavelength converter 3C. When the primary light 6 penetrates the wavelength converter 3C, the first phosphor 4 included in the wavelength converter 3C absorbs part of the primary light 6 and emits the first wavelength-converted light 7. In this way, the output light 15 including the primary light 6 and the first wavelength-converted light 7 is emitted from the back surface 3b of the wavelength converter 3C.

### (Effect)

The first phosphor 4 included in the wavelength converter 3C of the light emitting device 1C emits first wavelength-converted light 7 containing a large amount of the near-infrared light component, and thus the wavelength converter 3C of the light emitting device 1C emits output light 15 containing a large amount of the near-infrared light component.

Therefore, the light emitting device 1C achieves the same effect as that of the light emitting device 1A according to the first embodiment.

In addition, since the light emitting device 1C includes the light guide body 20, it is possible to have a configuration in which the solid-state light source 2 and the wavelength converter 3 are separated in distance. Therefore, with the light emitting device 1C, the degree of freedom in designing the arrangement of the solid-state light source 2 and the wavelength converter 3 in the light emitting device 1 becomes relatively large.

### [Fourth embodiment]

A light emitting device 1D (1) according to a fourth embodiment will be described. The light emitting device 1D according to the fourth embodiment includes the solid-state light source 2, the wavelength converter 3 (3D), and the light guide body 20. The light emitting device 1D according to the fourth embodiment is obtained by adding the light guide body 20 to the light emitting device 1B according to the second embodiment.

The difference between the light emitting device 1D according to the fourth embodiment and the light emitting device 1B according to the second embodiment is only in the light guide body 20. In addition, the light guide body 20 is the same as that used in the light emitting device 1C according to the third embodiment. Thus, only the action of the light emitting device 1D is described below, and the description of the components is omitted or simplified.

In the light emitting device 1D, the solid-state light source 2 and the wavelength converter 3D are arranged spaced apart in such a manner that the primary light 6 emitted from the solid-state light source 2 passes through the inside of the light guide body 20 to be emitted on the wavelength converter 3D.

### (Action)

The action of the light emitting device 1D will be described. As illustrated in Fig. 4, first, the primary light 6 emitted from the solid-state light source 2 passes through the inside of the light guide body 20 to be emitted on the front surface 3a of the wavelength converter 3D. The emitted primary light 6 penetrates the wavelength converter 3D. When the primary light 6 penetrates the wavelength converter 3D, the second phosphor 8 included in the wavelength converter 3D absorbs part of the primary light 6 and emits the second wavelength-converted light 9. Furthermore, the first phosphor 4 included in the wavelength converter 3D absorbs part of the primary light 6 and/or part of the second wavelength-converted light 9 to emit the first wavelength-converted light 7. In this way, the output light 15 including the primary light 6, the first wavelength-converted light 7, and the second wavelength-converted light 9 is emitted from the back surface 3b of the wavelength converter 3D.

### (Effect)

The first phosphor 4 included in the wavelength converter 3D of the light emitting device 1D emits the first wavelength-converted light 7 containing a large amount of the near-infrared light component, and thus the wavelength converter 3D of the light emitting device 1D emits the output light 15 containing a large amount of the near-infrared light component.

Therefore, the light emitting device 1D achieves the same effect as that of the light emitting device 1A according to the first embodiment.

In addition, since the wavelength converter 3D of the light emitting device 1D further includes the second phosphor 8, it becomes possible for the light emitting device 1D to easily adjust the spectral distribution of the output light according to the application.

In addition, since the light emitting device 1D includes the light guide body 20, it is possible to have a configuration in which the solid-state light source 2 and the wavelength converter 3 are separated in distance. Therefore, with the light emitting device 1D, the degree of freedom in designing the arrangement of the solid-state light source 2 and the wavelength converter 3 in the light emitting device 1 becomes relatively large.

### <Sensing system illumination system>

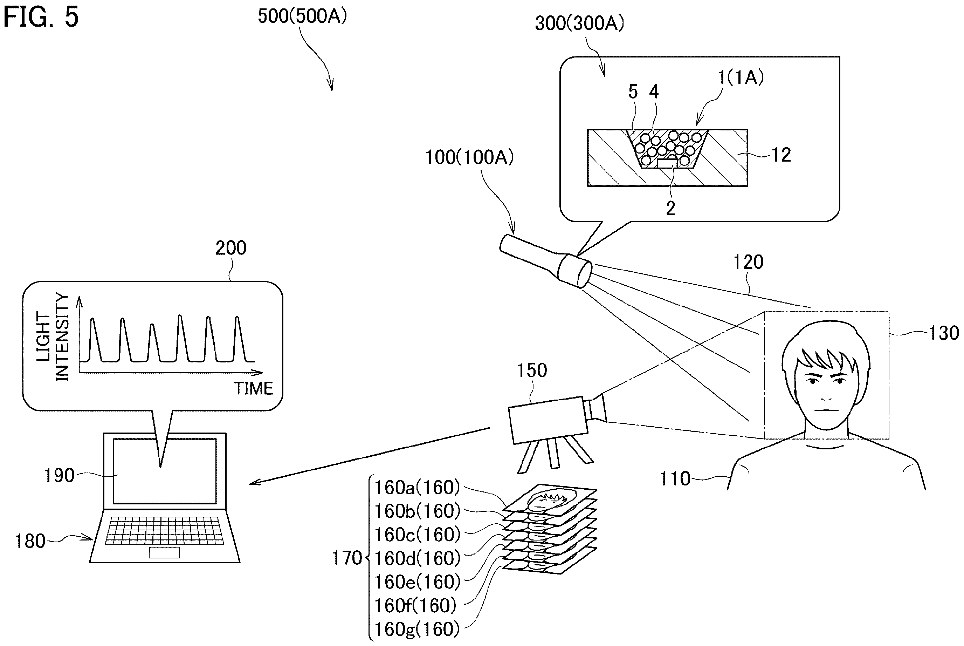

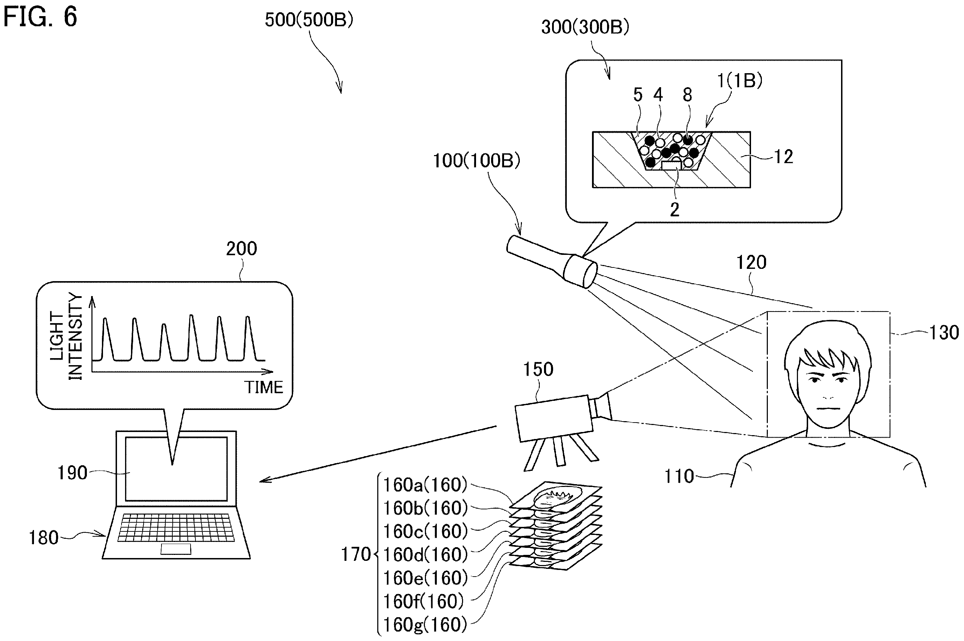

Next, sensing systems 500 (500A and 500B) according to embodiments are illustrated in Figs. 5 and 6. Fig. 5 is a diagram illustrating an example of a sensing system according to the first embodiment. Fig. 6 is a diagram illustrating an example of a sensing system according to the second embodiment.

Specifically, Fig. 5 illustrates the sensing system 500A (500) according to the first embodiment. Fig. 6 illustrates the sensing system 500B (500) according to the second embodiment.

The sensing systems 500A and 500B according to the first and second embodiments include the light emitting devices 1A and 1B according to the first and second embodiments, respectively.

Specifically, the sensing system 500A according to the first embodiment includes the sensing system illumination system 100A (100). The sensing system illumination system 100A uses the light emitting device 1A according to the first embodiment as a sensing system light source.

The sensing system 500B according to the second embodiment includes the sensing system illumination system 100B (100). The sensing system illumination system 100B uses the light emitting device 1B according to the second embodiment as a sensing system light source.

### [First embodiment]

The sensing system 500A according to the first embodiment will be described. The sensing system 500A according to the first embodiment illustrated in Fig. 5 includes the sensing system illumination system 100A, a spectral camera 150, and a computer 180.

### (Sensing system illumination system)

The sensing system illumination system 100A is an illumination system using the sensing system light source 300A (300) including the light emitting device 1A according to the first embodiment. Specifically, the sensing system illumination system 100A is a illumination system including the sensing system light source 300A (300) therein, the sensing system light source 300A (300) including a base material 12 and the light emitting device 1A according to the first embodiment formed in a recess part of the base material 12.

The sensing system illumination system 100A includes the sensing system light source 300A, and the sensing system light source 300A includes the light emitting device 1A according to the first embodiment. That is, the sensing system illumination system 100A and the sensing system light source 300A include the light emitting device 1A.

The sensing system illumination system 100A emits output light 15 from the light emitting device 1A in the sensing system light source 300A as irradiation light 120.

Note that the irradiation light 120 is light derived from the output light 15. In the sensing system illumination system 100A, the output light 15 is not usually emitted as it is, but is emitted as the irradiation light 120 after passing through a transparent plate or the like. The characteristics of light may change between the output light 15 before passing through a transparent plate or the like and the irradiation light 120 after passing through a transparent plate or the like, and thus the irradiation light 120 and the output light 15 are separately described for convenience. Note that when there is no member or field that changes physical characteristics of light between the output light 15 and the irradiation light 120, the output light 15 and the irradiation light 120 are usually the same light.

### (Spectral camera)

The spectral camera 150 is a camera capable of acquiring image data 170 including four or more spectral images 160 having different wavelengths. The spectral camera 150 is not particularly limited as long as it is capable of acquiring image data 170 including four or more spectral images 160. As the spectral camera 150, a multispectral camera, a hyperspectral camera, or the like is used, for example. A spectral camera such as a multispectral camera, a hyperspectral camera, or the like is preferable because it is easy to obtain highly accurate vital information 200 by comparing fine differences among four or more spectral images 160. It is also preferable that the spectral camera 150 be a CMOS multispectral camera, a CMOS hyperspectral camera, or the like using an inexpensive CMOS image sensor because the sensing system 500A can be made low-cost.

For example, as illustrated in Fig. 5, the sensing system illumination system 100A irradiates a subject 110 with the irradiation light 120, and the spectral camera 150 photographs a photographing area 130 of the subject 110 to acquire the image data 170. The spectral camera 150 illustrated in Fig. 5 is an example of a CMOS hyperspectral camera capable of acquiring image data 170 including seven spectral images 160 (160a, 160b, 160c, 160d, 160e, 160f, 160g).

Note that when the CMOS image sensor used for the spectral camera 150 is an inexpensive one, as illustrated in Fig. 7, the light receiving sensitivity of the CMOS image sensor is likely to be low in the near-infrared range NIR (wavelength 800 to 950 nm). However, in the sensing system 500A, the light emitting device 1A included in the sensing system illumination system 100A emits light containing first wavelength-converted light 7 that has the fluorescence peak FP_{F1} within a range of wavelengths of 700 or more and less than 900 nm and contains a large amount of near-infrared light. Specifically, the sensing system illumination system 100A emits the irradiation light 120 derived from the output light 15 containing the first wavelength-converted light 7 toward the subject 110.

Thus, even when a spectrum camera 150 using an inexpensive CMOS image sensor is used, the sensing system 500A can cover the shortcoming of the spectrum camera 150. That is, even when an inexpensive spectrum camera 150 including an inexpensive CMOS image sensor is used, the sensing system 500A can acquire high-quality image data 170 to obtain highly accurate vital information 200.

### (Computer)

The computer 180 is a member capable of calculating vital information 200 based on image data 170 acquired from the spectral camera 150. Software including a vital data calculation algorithm capable of calculating vital information 200 based on image data 170 is installed in the computer 180. Also, the computer 180 usually includes a display unit 190 capable of displaying vital information 200, as illustrated in Fig. 7. In the sensing system 500A, the display unit 190 is included in the computer 180. However, as a modified example of the sensing system 500A, it is also possible to use a sensing system 500 where the display unit 190 is separate from the computer 180.

Software installed in the computer 180 calculates vital information 200 using a vital data calculation algorithm and image data 170. Examples of the vital information 200 include information on blood pressure, pulse waves, and blood vessels deep in a living body. Fig. 7 illustrates an example where the vital information 200 is a pulse wave.

The image data 170 includes seven spectral images 160a, 160b, 160c, 160d, 160e, 160f, and 160g, and thus the amount of information is larger than that obtained by a conventional RGB camera. Thus, in the sensing system 500A, it is possible to calculate highly accurate vital information 200 using image data 170 having a large amount of information.

### (Action)

The action of the sensing system 500A will be described. As illustrated in Fig. 5, first, the irradiation light 120 is emitted from the sensing system illumination system 100A on the subject 110. The irradiation light 120 is light that is derived from the output light 15 including the first wavelength-converted light 7 and contains a large amount of a light component in the near-infrared range with the fluorescence peak FP_{F1} within a range of wavelengths of 700 or more and less than 900 nm.

Next, the spectral camera 150 photographs the photographing area 130 of the subject 110 on which the irradiation light 120 is emitted, and thus acquires the image data 170. Note that when the spectral camera 150 is an inexpensive spectral camera including an inexpensive CMOS image sensor, the light receiving sensitivity of the CMOS image sensor is likely to be low in the near-infrared range NIR (wavelength 800 to 950 nm).

However, in the sensing system 500A, the irradiation light 120 emitted from the sensing system illumination system 100A is light derived from the output light 15 including the first wavelength-converted light 7 and thus contains a large amount of a light component in the near-infrared range. Thus, in the sensing system 500A, even when the spectral camera 150 is an inexpensive spectral camera, it is possible to acquire high-quality image data 170 by using it in combination with the sensing system illumination system 100A.

In addition, the image data 170 obtained from the spectral camera 150 has a large amount of information, including seven spectral images 160a, 160b, 160c, 160d, 160e, 160f, and 160g. Thus, the sensing system 500A can acquire high-quality and information-rich image data 170.

Furthermore, the computer 180 acquires the image data 170 from the spectral camera 150 and calculates the vital information 200 based on the image data 170. The vital information 200 is calculated, for example, by inputting the seven spectral images 160a, 160b, 160c, 160d, 160e, 160f, and 160g included in the image data 170 to a vital data calculation algorithm in the computer 180. Since the computer 180 uses the high-quality and information-rich image data 170, it is possible to calculate vital information 200 having high accuracy. The calculated vital information 200 is displayed on the display unit 190 of the computer 180.

### (Effect)

In the sensing system 500A, the sensing system light source 300A and the sensing system illumination system 100A include the light emitting device 1A. Thus, the sensing system light source 300A and the sensing system illumination system 100A can provide a sensing system light source and a sensing system illumination system having a high fluorescence intensity in the near-infrared range (wavelength 800 to 950 nm).

The sensing system light source 300A and the sensing system illumination system 100A of the sensing system 500A include the light emitting device 1A and thus have a high fluorescence intensity in the near-infrared range (wavelength 800 to 950 nm). Hence, with the sensing system 500A, even when the spectral camera 150 is an inexpensive spectral camera, high-quality image data 170 can be acquired, and thus it is possible to calculate highly accurate vital information 200.

### [Modified example of first embodiment]

As a modified example of the sensing system 500A according to the first embodiment, a sensing system 500 including the light emitting device 1C instead of the light emitting device 1A can be used. The light emitting device 1C differs from the light emitting device 1A in that the light guide body 20 is arranged between the solid-state light source 2 and the wavelength converter 3C. According to the modified example of the sensing system 500A, even when the solid-state light source 2 and the wavelength converter 3C in the light emitting device 1C are arranged spaced apart, it becomes possible to efficiently guide the primary light 6 to the wavelength converter 3C.

### (Action)

The action of the modified example of the sensing system 500A is the same as that of the sensing system 500A except that it becomes possible to efficiently guide the primary light 6 to the wavelength converter 3C even when the solid-state light source 2 and the wavelength converter 3C in the light emitting device 1C are arranged spaced apart. Thus, the description of the action of the modified example of the sensing system 500A is omitted.

### (Effect)

The effect of the modified example of the sensing system 500A is the same as that of the sensing system 500A except that it becomes possible to efficiently guide the primary light 6 to the wavelength converter 3C even when the solid-state light source 2 and the wavelength converter 3C in the light emitting device 1C are arranged spaced apart.

### [Second embodiment]

The sensing system 500B (500) according to the second embodiment will be described. The sensing system 500B according to the second embodiment, which is illustrated in Fig. 6, includes the sensing system illumination system 100B, the spectral camera 150, and the computer 180.

The sensing system 500B according to the second embodiment uses the sensing system illumination system 100B instead of the sensing system illumination system 100A in the sensing system 500A according to the first embodiment. Thus, the sensing system 500B has the same configuration as the sensing system 500A except for the sensing system illumination system 100B. Hereinafter, the same components of the sensing system 500B and the sensing system 500A are denoted by the same reference signs, and the description of configurations and operations thereof is omitted.

### (Sensing system illumination system)

The sensing system illumination system 100B uses the light emitting device 1B instead of the light emitting device 1A of the sensing system illumination system 100A. Specifically, the light emitting device 1B uses the wavelength converter 3B instead of the wavelength converter 3A of the light emitting device 1A. In contrast to the wavelength converter 3A, the wavelength converter 3B further includes the second phosphor 8. Configurations and differences of the light emitting devices 1A and 1B, and those of the wavelength converters 3A and 3B have been described above. Thus, description of the configuration of the sensing system illumination system 100B is omitted.

### (Action)

The action of the sensing system 500B will be described. As illustrated in Fig. 6, first, the irradiation light 120 is emitted from the sensing system illumination system 100B on a subject 110. The irradiation light 120 is light derived from output light 15 including first wavelength-converted light 7 and second wavelength-converted light 9, and contains a large amount of a light component in the near-infrared range having the fluorescence peak FP_{F1} within a range of wavelengths of 700 or more and less than 900 nm.

Next, the spectral camera 150 photographs the photographing area 130 of the subject 110 on which the irradiation light 120 is emitted, and thus acquires the image data 170. Note that when the spectral camera 150 is an inexpensive spectral camera including an inexpensive CMOS image sensor, the light receiving sensitivity of the CMOS image sensor is likely to be low in the near-infrared range NIR (wavelength 800 to 950 nm).

However, in the sensing system 500B, the irradiation light 120 emitted from the sensing system illumination system 100B is light derived from the output light 15 including the first wavelength-converted light 7 and the second wavelength-converted light 9 and thus contains a large amount of a light component in the near-infrared range. Thus, in the sensing system 500B, even when the spectral camera 150 is an inexpensive spectral camera, it is possible to acquire high-quality image data 170 by using it in combination with the sensing system illumination system 100B.

Since the action of the sensing system 500B after acquiring the image data 170 is the same as that of the sensing system 500A after acquiring the image data 170, the description is omitted.

### (Effect)

In the sensing system 500B, the sensing system light source 300B and the sensing system illumination system 100B include the light emitting device 1B. Thus, the sensing system light source 300B and the sensing system illumination system 100B can provide a sensing system light source and a sensing system illumination system having a high fluorescence intensity in the near-infrared range (wavelength 800 to 950 nm).

The sensing system light source 300B and the sensing system illumination system 100B of the sensing system 500B include the light emitting device 1B and thus have a high fluorescence intensity in the near-infrared range (wavelength 800 to 950 nm). Hence, with the sensing system 500B, even when the spectral camera 150 is an inexpensive spectral camera, high-quality image data 170 can be acquired, and thus it is possible to calculate highly accurate vital information 200.

The wavelength converter 3B of the light emitting device 1B further includes the second phosphor 8. Thus, with the sensing system light source 300B, the sensing system illumination system 100B, and the sensing system 500B, it becomes possible to easily adjust the spectral distribution of the output light according to the application.

### [Modified example of second embodiment]

As a modified example of the sensing system 500B according to the second embodiment, a sensing system 500 including the light emitting device 1D instead of the light emitting device 1B can be used. The light emitting device 1D differs from the light emitting device 1B in that a light guide body 20 is arranged between the solid-state light source 2 and the wavelength converter 3D. According to the modified example of the sensing system 500B, even when the solid-state light source 2 and the wavelength converter 3D in the light emitting device 1D are arranged spaced apart, it becomes possible to efficiently guide the primary light 6 to the wavelength converter 3D.

### (Action)

The action of the modified example of the sensing system 500B is the same as that of the sensing system 500B except that it becomes possible to efficiently guide the primary light 6 to the wavelength converter 3D even when the solid-state light source 2 and the wavelength converter 3D in the light emitting device 1D are arranged spaced apart.

### (Effect)

The effect of the modified example of the sensing system 500B is the same as that of the sensing system 500B except that it becomes possible to efficiently guide the primary light 6 to the wavelength converter 3D even when the solid-state light source 2 and the wavelength converter 3D in the light emitting device 1D are arranged spaced apart.

### EXAMPLES

The light emitting device according to the above embodiments will be described in more detail below with examples, but the embodiments are not limited to these examples.

### [Example 1]

### (Preparation of phosphor)

The first phosphor 4 was synthesized using a preparation procedure using a solid-state reaction. Specifically, an oxide phosphor represented by the composition formula of Mg₃Ga₂GeO₈:Cr³⁺ (Cr³⁺ content 2.5%) was synthesized. Note that in synthesizing the oxide phosphor, the following compound powders were used as the main raw materials.

Magnesium oxide (MgO): purity 4N, manufactured by Tateho Chemical Industries Co., Ltd.

Germanium oxide (GeO₂): purity 4N, manufactured by Kojundo Chemical Lab. Co., Ltd.

Gallium oxide (Ga₂O₃): purity 4N, manufactured by Nippon Rare Metal, Inc.

Chromium oxide (Cr₂O₃): purity 3N, manufactured by Kojundo Chemical Lab. Co., Ltd.

First, the above raw materials were weighed to give the compound Mg₃Ga₂GeO₈:Cr³⁺ (Cr³⁺ content 2.5%) of a stoichiometric composition. Then, dry mixing was performed using a mortar and pestle, and a raw material for calcination was obtained.

The above calcination raw material was moved to an alumina crucible having a lid and was calcined for 2 hours in air at 1400 °C using a box-type electric furnace, and then the calcined material was lightly cracked to obtain a phosphor of example 1. Note that the sample after calcination was confirmed to be Mg₃Ga₂GeO₈:Cr³⁺ (Cr³⁺ content 2.5%) using an X-ray diffraction method.

### (Evaluation of phosphor)

### <Evaluation of fluorescence spectrum F_{F1}>

The fluorescence spectrum F_{F1} of the phosphor was evaluated using an absolute PL quantum yield measuring device C9920-02G (manufactured by Hamamatsu Photonics K.K.). In Figs. 9 and 12, the fluorescence spectrum F_{F1} when excited at an excitation wavelength of 425 nm was denoted as F₁.

The wavelength of the fluorescence peak FP₁ of the fluorescence spectrum F₁ was 800 nm.

The shape of the fluorescence spectrum F₁ was such that the fluorescence spectrum data group FD, which is an aggregate of spectral intensities of the fluorescence spectrum F₁ at every 10 nm, exhibited a unimodal shape within a range of wavelengths of 700 or more and less than 900 nm. That is, when the shape of the fluorescence spectrum F₁ is observed microscopically, a large number of jagged shapes due to vertical fluctuations with low intensities are observed. However, the fluorescence spectrum data group FD, which is an aggregate of spectral intensities of the fluorescence spectrum F₁ at every 10 nm, has a shape that indicates a unimodal shape within a range of wavelengths of 700 or more and less than 900 nm, although this is not illustrated.

In addition, the shape of the fluorescence spectrum F₁ has a high similarity to a normal distribution curve centered on the wavelength 800 nm of the fluorescence peak FP₁.

### <Evaluation of half width of fluorescence peak FP₁>

From the fluorescence spectrum F₁ of the phosphor, a half width HW₁ of the fluorescence peak FP₁ was measured. The half width HW₁ of the fluorescence peak FP₁ was 174 nm.

### <Evaluation of excitation spectrum X_{F1}>

The excitation spectrum X_{F1} of the phosphor was evaluated using an absolute PL quantum yield measuring device C9920-02G (manufactured by Hamamatsu Photonics K.K.). In Fig. 13, the excitation spectrum X_{F1} when the fluorescence was emitted at a fluorescence wavelength of 915 nm was denoted as X₁.

The excitation peak XP₁ of the excitation spectrum X₁ had two excitation peaks XP₁₁ (wavelength 425 nm) and XP₁₂ (wavelength 590 nm) within a range of wavelengths of 370 or more and less than 700 nm. That is, the excitation spectrum X₁ exhibited a multimodal shape within the range of wavelengths of 370 or more and less than 700 nm.

In addition, M_{BS}, which is the maximum intensity value of the blue-side spectral portion X_{BS} in the wavelength range of 370 or more and less than 520 nm, and M_{RS}, which is the maximum intensity value of the red-side spectral portion X_{RS} in the wavelength range of 520 or more and less than 700 nm, were calculated in the excitation spectrum X₁. Specifically, from Fig. 13, M_{BS} is the height of the excitation peak XP₁₁ (wavelength 425 nm), and M_{RS} is the height of the excitation peak XP₁₂ (wavelength 590 nm). The maximum intensity ratio M_{RS}/M_{BS} obtained by dividing M_{RS} by M_{BS} was 95% from Fig. 13.

### [Example 2]

### (Preparation of phosphor)

An oxide phosphor was synthesized in the same manner as in example 1 except that the oxide phosphor represented by the composition formula of Mg₃Ga₂GeO₈:Cr³⁺ (Cr³⁺ content of 2.0%) was synthesized as the first phosphor 4. Note that the sample after calcination was confirmed to be Mg₃Ga₂GeO₈:Cr³⁺ (Cr³⁺ content 2.0%) using an X-ray diffraction method.

### (Evaluation)

### <Evaluation of fluorescence spectrum F_{F1}>

The fluorescence spectrum F_{F1} of the phosphor was evaluated using an absolute PL quantum yield measuring device C9920-02G (manufactured by Hamamatsu Photonics K.K.). In Fig. 9, the fluorescence spectrum F_{F1} when excited at an excitation wavelength of 425 nm was denoted as F₂.

The wavelength of the fluorescence peak F_{P2} of the fluorescence spectrum F₂ was 780 nm.

The shape of the fluorescence spectrum F₂ was such that the fluorescence spectrum data group FD, which is an aggregate of spectral intensities of the fluorescence spectrum F₂ at every 10 nm, exhibited a unimodal shape within the range of wavelengths of 700 or more and less than 900 nm. That is, when the shape of the fluorescence spectrum F₂ is observed microscopically, a large number of jagged shapes due to vertical fluctuations with low intensities are observed. However, the fluorescence spectrum data group FD, which is the aggregate of spectral intensities of the fluorescence spectrum F₂ at every 10 nm, has a shape that illustrates a unimodal shape within the wavelength range of 700 or more and less than 900 nm, although this is not illustrated.

In addition, the shape of the fluorescence spectrum F₂ has less similarity to a normal distribution curve compared to the shape of the fluorescence spectrum F₁ according to example 1.

### <Evaluation of half width of fluorescence peak FP₂>

From the fluorescence spectrum F₂ of the phosphor, a half width HW₂ of the fluorescence peak F_{P2} was measured. The half width HW₂ of the fluorescence peak F_{P2} was 180 nm.

### [Comparative example 1]

For the Mg₃Ga₂GeO₈ phosphor (P2 phosphor) disclosed in Non-Patent Literature 1, the fluorescence spectrum F_{P2} and excitation spectrum X_{P2} obtained from Non-Patent Literature 1 are illustrated in Figs. 12 and 13.

### (Evaluation)

### <Examination of fluorescence spectrum F_{P2}>

In Non-Patent Literature 1, the fluorescence spectrum F_{P2} illustrated in Figs. 12 and 13 is regarded as a fluorescence spectrum when excited at an excitation wavelength of 425 nm.

The wavelength of the fluorescence peak FP_{P2} of the fluorescence spectrum F_{P2} is about 915 nm.

The shape of the fluorescence spectrum F_{P2} is such that the fluorescence spectrum data group FD, which is an aggregate of spectral intensities of the fluorescence spectrum F_{P2} at every 10 nm, does not exhibit a unimodal shape within the range of wavelengths of 700 or more and less than 900 nm.

In addition, the shape of the fluorescence spectrum F_{P2} has a very low similarity to a normal distribution curve centered on the wavelength 915 nm of the fluorescence peak FP_{P2}.

### <Examination of half width of fluorescence peak FP_{P2}>

From the fluorescence spectrum F_{P2} of the phosphor, a half width HW_{P2} of fluorescence peak FP_{P2} was measured. The half width HW_{P2} of the fluorescence peak FP_{P2} was about 250 nm.

### <Examination of excitation spectrum X_{P2}>

In Non-Patent Literature 1, the excitation spectrum X_{P2} illustrated in Figs. 12 and 13 is regarded as an excitation spectrum when fluorescence is emitted at a fluorescence wavelength of 915 nm.

The excitation peak XP_{P2} of the excitation spectrum X_{P2} has two excitation peaks XP_{P21} (wavelength 425 nm) and XP_{P22} (wavelength 605 nm) within a range of wavelengths of 370 or more and less than 700 nm. That is, the excitation spectrum X_{P2} exhibited a multimodal shape within the range of wavelengths of 370 or more and less than 700 nm.

In addition, M_{BS}, which is the maximum intensity value of the blue-side spectral portion X_{BS} in the wavelength range of 370 or more and less than 520 nm, and M_{RS}, which is the maximum intensity value of the red-side spectral portion X_{RS} in the wavelength range of 520 or more and less than 700 nm, were calculated in the excitation spectrum X_{P2}. Specifically, from Fig. 13, M_{Bs} is the height of the excitation peak XP_{P21} (wavelength 425 nm), and M_{RS} is the height of the excitation peak XP_{P22} (wavelength 605 nm). The maximum intensity ratio M_{RS}/M_{BS} obtained by dividing M_{RS} by M_{BS} was about 45% from Fig. 13.

### [Example 3]

A sheet-like wavelength converter 3A was made using the first phosphor 4 synthesized in example 1. Then, the sheet-like wavelength converter 3A was arranged on the surface of the solid-state light source 2 to manufacture the light emitting device 1A.

### (Solid-state light source)

A Luxeon M18s High W350 Type manufactured by Lumileds Holding B.V. was used as the solid-state light source 2. The light emitted by this solid-state light source 2 was light that satisfied "bikousyoku" defined by Panasonic Corporation's lighting technology. "Bikousyoku" is usually defined as "light that enhances skin and object color more beautifully by relatively improving redness by reducing the intensity of a light component at a wavelength around 570 to 580 nm".

### (Wavelength converter)

### <First phosphor>

As the first phosphor 4, the first phosphor 4 synthesized in example 1 was used.

### <Sealant>

Dimethyl silicone resin KER-2937-A/B (manufactured by Shin-Etsu Chemical Co., Ltd.) was used as the sealant 5.

### <Manufacturing of wavelength converter>

The first phosphor 4 was mixed with the sealant 5 to make the first phosphor 4 be 20% by volume, and the mixture was applied to the surface of a glass substrate and was cured by being held at 150 °C for 2 hours in a thermostatic chamber. Then, a sheet-like wavelength converter 3A was manufactured by being peeled from the glass substrate. The wavelength converter 3A was 30 mm long, 30 mm wide, and 235 µm thick. Hereinafter, the obtained wavelength converter 3A is also referred to as an "MGGO sheet".

### (Manufacturing of light emitting device)

A light emitting device 1A was manufactured by arranging the MGGO sheet on the surface of the solid-state light source 2. The MGGO sheet was brought into close contact with the surface of the solid-state light source 2.

### (Evaluation of light emitting device)

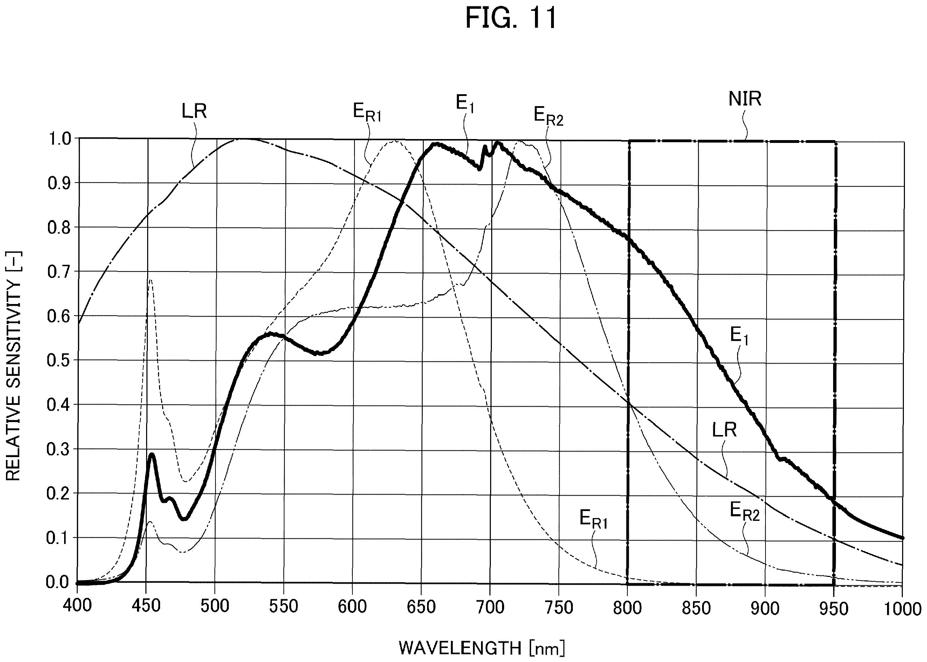

Power was supplied to the solid-state light source 2 to cause the solid-state light source 2 to emit primary light 6. Then, an emission spectrum E₁ of the output light 15 including the primary light 6 emitted by the solid-state light source 2 and the first wavelength-converted light 7 emitted by the first phosphor 4 in the MGGO sheet due to receiving this primary light 6 was measured. The emission spectrum E₁ was evaluated using an absolute PL quantum yield measuring device C9920-02G (manufactured by Hamamatsu Photonics K.K.). The emission spectrum E₁ is illustrated in Fig. 11.

Note that Fig. 11 also illustrates the light receiving sensitivity curve LR of a CMOS image sensor included in a general CMOS camera.

### [Reference example 1]

### (Manufacturing of light emitting device)

A light emitting device including only the solid-state light source 2 of example 3 was used as the light emitting device.

### (Evaluation of light emitting device)

Power was supplied to the light emitting device including only the solid-state light source 2 to cause the solid-state light source 2 to emit primary light 6. Then, an emission spectrum E_{R1} of the primary light 6 emitted by the solid-state light source 2 was measured as in example 3. The emission spectrum E_{R1} is illustrated in Fig. 11.

### [Reference example 2]

### (Solid-state light source)

The same solid-state light source 2 as in example 3 was prepared.

### (Wavelength converter)

A sheet-like wavelength converter 3A was prepared in the same manner as in example 3 except that (Gd_{0.8}La_{0.2})₃(Ga,Cr)₂(GaO₄)₃, which is a well-known phosphor, was used as the first phosphor 4. Hereinafter, the obtained wavelength converter 3A is also referred to as a "GLGG sheet".

### (Manufacturing of light emitting device)

A light emitting device 1A was manufactured by arranging the GLGG sheet on the surface of the solid-state light source 2. The GLGG sheet was brought into close contact with the surface of the solid-state light source 2.

### (Evaluation of light emitting device)

The obtained light emitting device 1A was evaluated in the same manner as example 3. The obtained light emission spectrum is illustrated in Fig. 11 as E_{R2}.

### (Evaluation of example 3 and reference example 2)

As illustrated in Fig. 11, the emission spectrum E₁ of example 3 was found to have a higher intensity at around 850 nm than the emission spectrum E_{R2} of reference example 2.

Although the contents of embodiments have been described above along with the examples, the embodiments are not limited to these descriptions, and it is obvious to those skilled in the art that various modifications and improvements are possible.

The entire contents of Japanese Patent Application No. 2021-012659 (filed on January 29, 2021) are incorporated herein by reference.

Although the present embodiment has been described above, it is not limited to these descriptions, and various modifications can be made within the scope of the gist of the present embodiment.

### INDUSTRIAL APPLICABILITY

The present disclosure is capable of providing a phosphor, a light emitting device, a sensing system light source, and a sensing system illumination system that have a high fluorescence intensity in the near-infrared range (wavelength 800 to 950 nm).

### REFERENCE SIGNS LIST

1, 1A, 1B, 1C, 1D Light emitting device (sensing system light source)
2 Solid-state light source
3, 3A, 3B, 3C, 3D Wavelength converter
4 First phosphor
6 Primary light
8 Second phosphor
100, 100A, 100B Sensing system illumination system
E_{LS} Emission spectrum
EP_{LS} Emission peak
F_{F1}, F_{F2} Fluorescence spectrum
FP_{F1}, FP_{F2} Fluorescence peak
FD_{F1} Fluorescence spectrum data group
X_{F1} Excitation spectrum
X_{BS} Blue-side spectral portion
X_{RS} Red-side spectral portion
M_{BS} Maximum intensity value
M_{RS} Maximum intensity value

## Claims

1. A phosphor that contains Cr³⁺ and configures to emit near-infrared light, wherein
a host crystal of the phosphor has a crystal structure same as that of a compound Mg₃Ga₂GeO₈,
a fluorescence spectrum F_{F1} has a fluorescence peak FP_{F1} within a range of wavelengths of 700 or more and less than 900 nm, and
a fluorescence spectrum data group FD that is an aggregate of spectral intensities of the fluorescence spectrum F_{F1} at every 10 nm exhibits a unimodal shape within the range of wavelengths of 700 or more and less than 900 nm.

2. The phosphor according to claim 1, wherein a half width of the fluorescence peak FP_{F1} is 120 or more and less than 200 nm.

3. The phosphor according to claim 1 or 2, wherein an excitation spectrum X_{F1} exhibits a multimodal shape within a range of wavelengths of 370 or more and less than 700 nm, and
in the excitation spectrum X_{F1}, when a maximum intensity value of a blue-side spectral portion X_{BS} that is a wavelength range of wavelengths of 370 or more and less than 520 nm is M_{BS} and a maximum intensity value of a red-side spectral portion X_{RS} that is a wavelength range of wavelengths of 520 or more and less than 700 nm is M_{RS}, a maximum intensity ratio M_{RS}/M_{BS} obtained by dividing M_{RS} by M_{BS} is 70% or more.

4. The phosphor according to any one of claims 1 to 3, wherein the host crystal has a composition represented by formula (1) below and a part thereof is replaced with Cr,
M^{II}ₐM^{XIII}_{b}M^{XIV}_{c}O_{d} (1)
in the formula, M^{II} is a bivalent element, M^{XIII} is a group 13 element, M^{XIV} is a group 14 element, 'a' is 2.7 to 3.3, 'b' is 1.2 to 2.8, 'c' is 0.8 to 1.2, and 'd' is 7.2 to 8.8.

5. The phosphor according to claim 4, wherein the M^{II} contains Mg, the M^{XIII} contains Ga, and the M^{XIV} contains Ge.

6. A light emitting device, comprising:
the phosphor according to any one of claims 1 to 5; and
a solid-state light source that configures to emit light in which an emission peak EP_{LS} of an emission spectrum E_{LS} is present on a shorter wavelength side of a fluorescence peak FP_{F1} of a fluorescence spectrum FL₁ of the phosphor.

7. The light emitting device according to claim 6, comprising the phosphor as a first phosphor, and
further comprising a second phosphor that is a phosphor in which a fluorescence peak FP_{F2} of a fluorescence spectrum F_{F2} is present on a shorter wavelength side of the fluorescence peak FP_{F1} of the fluorescence spectrum F_{F1} of the first phosphor, wherein
in the solid-state light source, an emission peak EP_{LS} of an emission spectrum E_{LS} is present on a shorter wavelength side of the fluorescence peak FP_{F2} of the fluorescence spectrum F_{F2} of the second phosphor.

8. The light emitting device according to claim 7, wherein the second phosphor includes a phosphor having a garnet crystal structure containing Ce³⁺.

9. The light emitting device according to any one of claims 6 to 8, wherein the light emitting device is used in combination with a light source that emits white light.

10. A sensing system light source, comprising:
the light emitting device according to any one of claims 6 to 9.

11. A sensing system illumination system, comprising:
the light emitting device according to any one of claims 6 to 9.
